(19) Europäisches Patentamt

European Patent Office

Office européen des brevets

(11) **EP 1 039 598 A2**

(12) **EUROPEAN PATENT APPLICATION**

(43) Date of publication:
**27.09.2000 Bulletin 2000/39**

(51) Int. Cl.$^7$: **H01S 5/12**

(21) Application number: **00302095.5**

(22) Date of filing: **15.03.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **24.03.1999 JP 7997899**

(71) Applicant: **NEC Corporation
Minato-ku, Tokyo 108-8001 (JP)**

(72) Inventor:
**Huang, Yidong,
c/o NEC Corporation
Tokyo 108-8001 (JP)**

(74) Representative:
**Abnett, Richard Charles
REDDIE & GROSE
16 Theobalds Road
London WC1X 8PL (GB)**

(54) **Distributed feedback semiconductor laser**

(57)    In a distributed feedback semiconductor laser whose optical feedback is provided at least by a diffraction grating (2), an active layer (4) has a quantum well structure comprising a well layer and a barrier layer, and said well layer is made of a tensile strain quantum well layer. The semiconductor laser has a simple structure and an easy manufacturing process and, in addition, an excellent resistance against return light, while having excellent laser characteristics.

Fig. 4

EP 1 039 598 A2

**Description**

BACKGROUND OF THE INVENTION

1. Field of the Invention

The present invention relates to a semiconductor laser and more particularly to a distributed feedback semiconductor laser with strong capacity to tolerate return light which is utilized as an integrated light source.

2. Description of the Related Art

The semiconductor laser is, at present, widely used as a light source for a high-volume long-distance optical fiber communication. However, the conventional semiconductor laser has a problem that a very small amount of return light reflected back from optical components such as optical connectors may induce noises in the inside of the semiconductor laser and cause code errors in transmission. The optical isolator used to remove such return light from the semiconductor laser has drawbacks of requiring a large number of manufacturing steps to work materials and make assembly in fabrication thereof and, thus, of costing a great deal. Accordingly, there has been sought a new development of a semiconductor laser with strong capacity to tolerate return light, possible to be used without an optical isolator, in other words, a semiconductor laser having an excellent resistance against return light (hard to be affected by return light).

One example of known laser structure designed to reduce noises induced by return light (return light induction noises) is described in an invention relating to a distributed feedback semiconductor laser (referred to as DFB laser, hereinafter) as shown in Fig. 8 (disclosed in Japanese Patent Application Laid-open No. 17384/1992). In that invention, an active layer 83 of a known DFB laser is divided into two regions, an excitation region (a region into which a current is introduced) and a non-excitation region, and with this non-excitation region being set at a position coming into contact with an edge face, a diffraction grating in the non-excitation region is utilized as a distributed reflector. In this way, return light can be inhibited from entering the excitation region of the active layer, even if the edge face is not coated with a multi-layered dielectric film.

In a laser with such a known structure, however, reflectivities of the non-excitation region against both emission light of the laser and return light to the laser are the same so that, when a good resistance against return light is provided, a sufficient differential efficiency cannot be obtained. Moreover, as a loss in the non-excitation region is considerable, a low threshold laser is difficult to acquire.

SUMMARY OF THE INVENTION

Firstly, in accordance with an aspect of the present invention, there is presented a distributed feedback semiconductor laser whose optical feedback is provided at least by a diffraction grating; wherein

an active layer has a quantum well structure comprising a well layer and a barrier layer; and
said well layer is made of a tensile strain quantum well layer.

Further, in accordance with a second aspect of the present invention, there is presented the distributed feedback semiconductor laser as set forth for the first aspect; wherein

said grating is formed only partially along the direction of the cavity length; and
the region with said grating being formed is specifically located on the side of one edge face, while a high reflection coating film is applied onto the other edge face on the side where no grating is formed.

Further, in accordance with a third aspect of the present invention, there is presented the distributed feedback semiconductor laser as set forth for the first aspect; wherein

a grating contained within the laser cavity is divided into M regions (M is an integer satisfying M>2) along the direction of the cavity length, and a phase shift section is interposed in every interval between said regions; and
the total amount of phase shifts of said phase shift sections corresponds to $\lambda/m$ ($\lambda$ is the oscillation wavelength and m is a positive real number).

Further, in accordance with another aspect of the present invention, there is presented the distributed feedback semiconductor laser as set forth for the third aspect; wherein

said phase shift sections are specifically located on the side of the edge face for laser emission.

Further, in accordance with another aspect of the present invention, there is presented the distributed feedback semiconductor laser as set forth for the first aspect; wherein

said grating is formed in such a manner as the grating period gradually changes from the center of the laser cavity towards both edge faces, with the rates of changes in both directions having the same absolute value but the reversed sign to each other.

Further, in accordance with another aspect of the present invention, there is presented the distributed feedback semiconductor laser as set forth for the first aspect; wherein

a grating contained within the laser cavity is divided into a plurality of regions along the direction of the cavity length, and the grating period, at least, in one of these regions is different from the rest; and
the amount of phase shifts over the whole grating corresponds to $\lambda/m$ ($\lambda$ is the oscillation wavelength and m is a positive real number).

A distributed feedback semiconductor laser having a tensile strain quantum well active layer in accordance with the present invention has a small linewidth enhancement factor for the active layer so that a change in refractive index of the inside of the semiconductor laser cavity which may be caused by return light reflected back from the outside or the direct modulation can be well controlled and, thus, fluctuations of the optical output and the oscillation wavelength can be inhibited. Consequently, a semiconductor laser with an excellent resistance against return light as well as a low chirping has become obtainable. Furthermore, a semiconductor laser of the present invention can produce the above effects without damaging its intrinsic laser characteristics, and besides a simple structure it possesses ensures an easy process for manufacturing.

BRIEF DESCRIPTION OF THE DRAWINGS

Fig. 1 is a diagram illustrating a generation mechanism of optical output fluctuations in a semiconductor laser, which are induced by return light.
Fig. 2 is a set of graphs showing calculated variations of the optical outputs against time, which explain fundamentals of a semiconductor laser of the present invention.
Fig. 3 is a pair of graphs illustrating fundamentals of a semiconductor laser embodying the present invention. Fig. 3(a) shows calculated linewidth enhancement factors and Fig. 3(b), gain spectra.
Fig. 4 is a schematic view showing a structure of a semiconductor laser according to the present invention.
Fig. 5 is a schematic view showing a structure of another semiconductor laser according to the present invention.
Fig. 6 is a schematic view showing a structure of another semiconductor laser according to the present invention.
Fig. 7 is a set of schematic views showing structures of diffraction gratings used in semiconductor lasers according to the present invention.

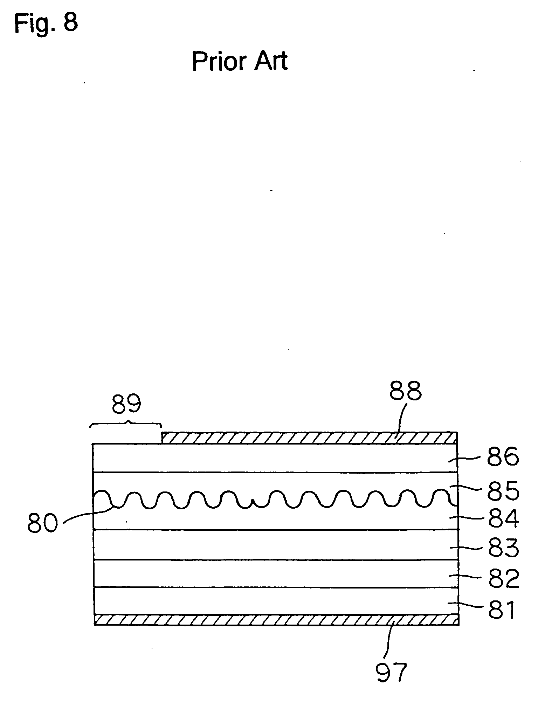

Fig. 8 is a schematic cross-sectional view showing a structure of a known semiconductor laser.

DETAILED DESCRIPTION OF THE PREFERRED EMBODIMENTS

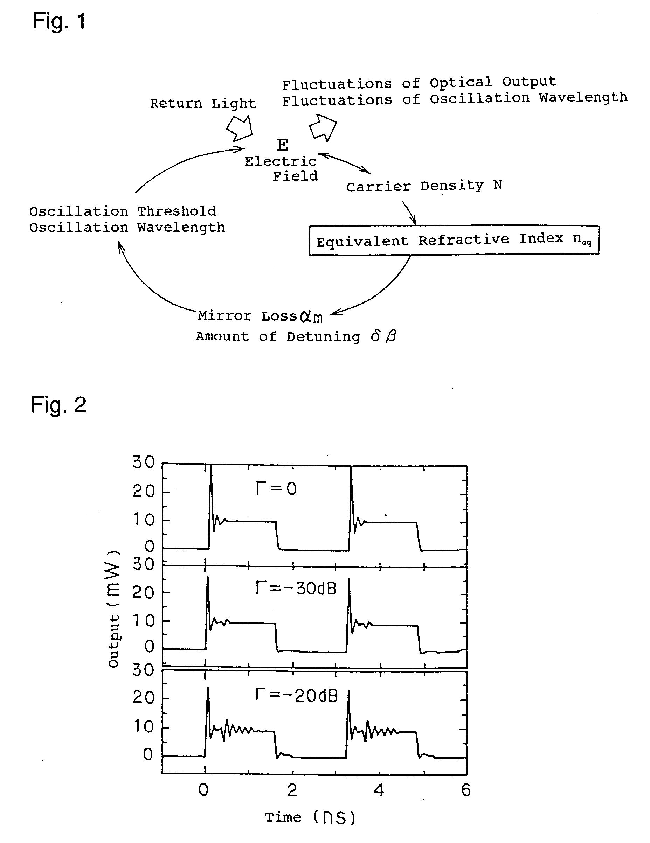

Fig. 1 is a diagram illustrating a generation mechanism of optical output fluctuations in a DFB laser which are induced by return light. When return light enters a cavity of a DFB laser, the electric field E and the carrier density N within the laser are varied and this leads to a change in an equivalent refractive index $n_{eq}$. In consequence, oscillation conditions of the DFB laser, namely the mirror loss $\alpha_m$ (relating to the oscillation threshold) as well as the amount of detuning $\delta\beta$ (relating to the oscillation wavelength) are altered so that the optical output and the oscillation wavelength $\lambda$ are changed. Here, $\delta\beta = 2 n_{eq} \pi (1/\lambda - 1/\lambda_B)$, where $\lambda_B$ is the Bragg wavelength.
Fig. 2 shows calculated results of optical output variations of the DFB laser at the time of digital modulation, with the return light at 0, - 20 dB and -30 dB, respectively, which were obtained through the large signal analysis. Fig. 2 indicates that, when return light enters, with vacillation of the optical output taking place, a fluctuation component such as shown in the drawing is added to a Hi level of the response waveform. Such output fluctuations may pass through a filter and lead to an outbreak of responsivity penalties in a communication system. The smaller fluctuations of the optical output in the DFB laser are, the stronger its capacity to tolerate return light is. As clearly seen in the mechanism shown in Fig. 1, a control over a change in an equivalent refractive index can inhibit oscillation conditions of the DFB laser from changing and, therefore, can reduce fluctuations of the optical output as well as the oscillation wavelength.

Meanwhile, in a tensile strain multiple quantum well (a tensile strain MQW), a light whole band is raised to become a first level of a valance band thereof, owing to the effect of tensile strain. As a result, a high differential gain g and a low linewidth enhancement factor $\alpha$ can be obtained.

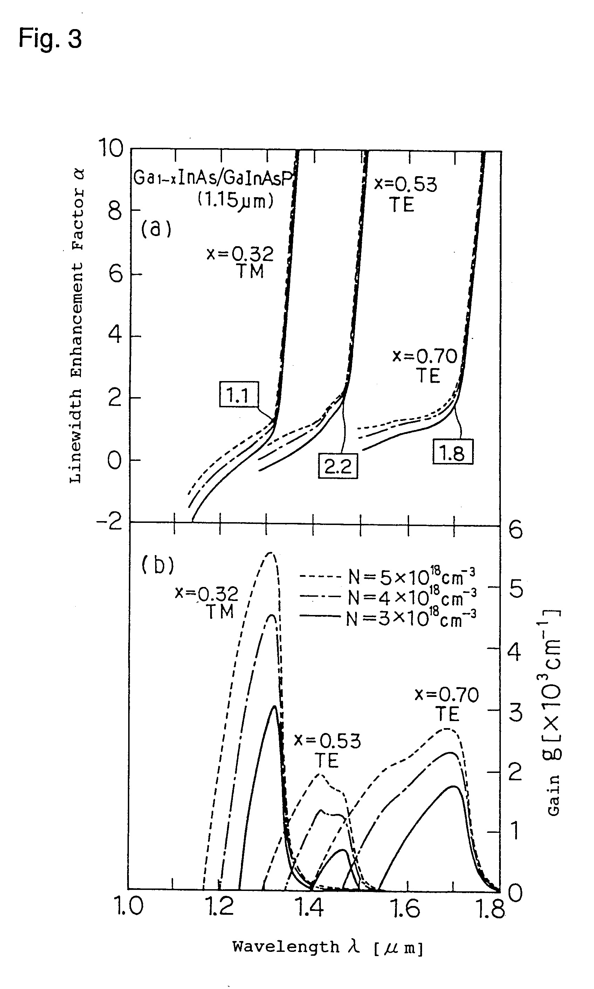

Fig. 3(b) shows gain spectra of a tensile strain single quantum well (TM (x=0 . 32)), a compressive strain single quantum well (TE (x=0 . 70)) and a non-strain single quantum well (TE (x=0 . 53)). As seen in the drawing, with increasing injected carrier density N, the gain peak of the tensile strain quantum well grows a great deal. In other words, the differential gain dg/dN of the tensile strain quantum well is considerably large, compared with those of the compressive strain quantum well and non-strain quantum well.

Fig. 3(a) shows calculated results of linewidth enhancement factors (without taking account of the free carrier plasma effect) of the tensile strain single quantum well, the compressive strain single quantum well and the non-strain single quantum well. It was found that, since the linewidth enhancement factor $\alpha$ is given by an equation $\alpha = ( dn / dN ) / ( dg / dN )$, the line width enhancement factor for the tensile strain quantum well which has a large differential gain is small, and the value of the linewidth enhancement factor at the gain peak wavelength for this quantum well is equal to or less than 2/3 of that for the compressive strain quantum well.

Table 1 summarizes the free carrier plasma effect on the linewidth enhancement factor $\alpha$. Here, $L_W$ in the Table represents the thickness of the quantum well. It was found that the linewidth enhancement factors $\alpha$ for the compressive strain quantum well (the compressive strain QW) and the non-strain quantum well (the non-strain QW) are increased a great deal by the free carrier plasma effect because the oscillation mode for both of those quantum wells is TE mode. In contrast with this, in the case of the tensile strain quantum well (the tensile strain QW), the first valance electronic level is a light hole band so that oscillation in TM mode is possible. It is thought that, since the electric field polarized oscillation in TM mode occurs in the direction normal to the quantum well, the movements of free carriers in this direction are suppressed and, therefore, no deterioration of the linewidth enhancement factor is resulted from the plasma effect. Consequently, it was found that, when the free carrier plasma effect is taken into consideration, the linewidth enhancement factor for the tensile strain quantum well becomes still smaller than those for the other two quantum wells and is, indeed, 1/3 or so of that for the compressive strain quantum well.

## Table 1

| $N = 3 \times 10^{18} \, cm^{-3}$ $L_W = 5$ nm | | Plasma effect | |
|---|---|---|---|
| | | Not considered | Considered |
| Linewidth enhancement factor | Compressive strain QW | 1.8 | 3.1 |
| | Non-strain QW | 2.2 | 3.8 |
| | Tensile strain QW | 1.1 | 1.1 |

In a laser with a small linewidth enhancement factor $\alpha$, a change in refractive index due to change of carrier density is small. Because of this, oscillation conditions of the laser can be inhibited from changing and, therefore, fluctuations of the optical output as well the oscillation wavelength can be reduced. Accordingly, in the present system, through the use of a structure in which a tensile strain quantum well with a small linewidth enhancement factor is employed for the active layer, an improvement in the resistance against return light of the DFB laser is achieved.

Meanwhile, at the time of direct modulation, an application of a modulation signal to the DFB laser forces to change the carrier density within laser cavity. This leads to a change in the refractive index and, consequently, to shifts of the oscillation wavelength. In the present invention, because the active layer in structure utilizes a tensile strain quantum well with a small linewidth enhancement factor, a change in the refractive index is controlled and fluctuations of the oscillation wavelength, reduced and, therefore, a DFB laser with a low chirping can be acquired.

Now, the preferred embodiments of the present invention are described below.

It is to be understood that the sizes, shapes and arrangements of various components in the accompanying drawing are not drawn to scale but schematically for the purpose of clear illustration.

First embodiment

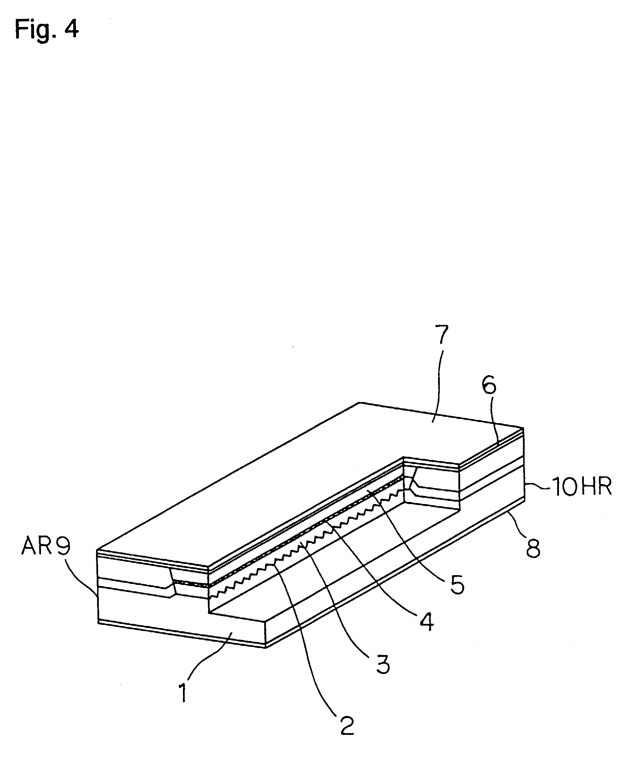

Fig. 4 is a schematic view showing a structure of a semiconductor laser that is a first embodiment of the present invention.

A semiconductor laser of the present embodiment has a cavity length of 250 $\mu$m and a grating 2 thereof is formed on an InP semiconductor substrate 1 by a known method of electron beam exposure and lithography. Over this grating 2, an InGaAsP optical waveguide layer 3 (0.1 $\mu$m in thickness), a triple-layered tensile strain multiple quantum well active layer 4 (well layers : three 12 nm-thick layers; barrier layers : two 15 nm-thick layers), an InGaAsP clad layer 5 (3 $\mu$m in thickness) and an InP cap layer 6 (0.2 $\mu$m in thickness) are formed in this order.

Further, by a known method of electrode fabrication, electrodes 7 and 8 are formed on the side of the InP cap layer 6 and on the side of the InP semiconductor substrate 1, respectively. Further, an anti-reflection (AR) coating film 9 and a high-reflection (HR) coating film 10 are applied to a front edge face of the semiconductor laser and to a rear edge face, respectively.

The magnitude of the tensile strain of the quantum well is set to be not less than - 0.5 % in order to make the linewidth enhancement factor of the well layer 3 or less.

Further, the depth of etching for fabrication of said grating 2 is set to be 0. 03 $\mu$m so as to set the DFB coupling constant $\kappa$ to be approximately 70 / cm. The grating period $\Lambda$ herein is 202.7 nm.

In the present embodiment, a well layer constituting a quantum well structure is preferably a tensile strain quantum well layer whose linewidth enhancement factor $\alpha$ at the gain peak wavelength is not greater than 3 and more preferably one with a linewidth enhancement factor $\alpha$ of 0 to 3.

Because the active layer of the DFB laser of the present embodiment utilizes a tensile strain quantum well with a small linewidth enhancement factor, in this manner, fluctuations of the optical output caused by return light can be inhibited. Consequently, the resistance against return light can be enhanced. Furthermore, shifts of the oscillation wavelength resulting from the direct modulation can be controlled and, therefore, a DFB laser with a low chirping can be accomplished.

Second embodiment

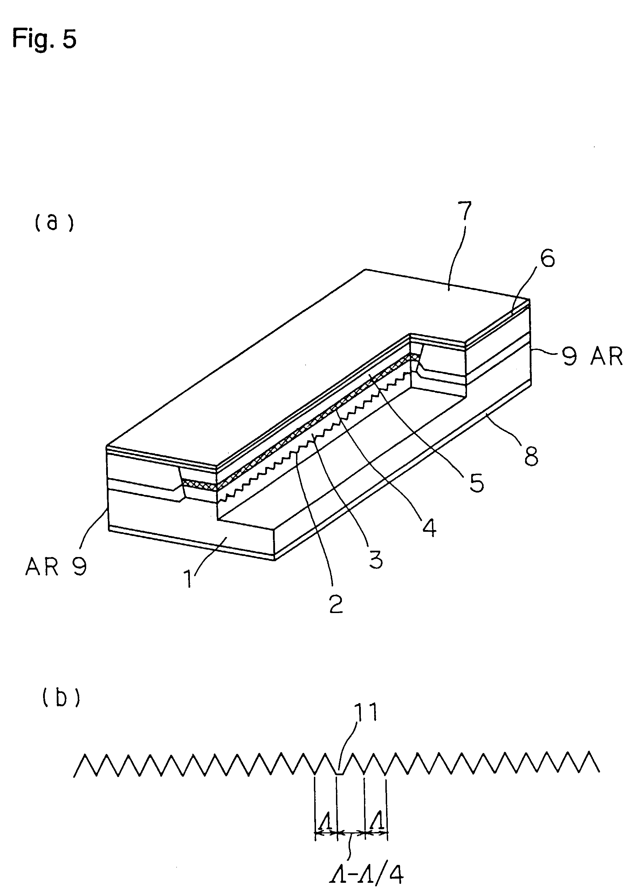

Fig. 5 (a) is a schematic view showing a structure of a semiconductor laser that is a second embodiment of the present invention.

A semiconductor laser of the present embodiment has the same structure as the first embodiment except that a grating 2 with a phase shift section 11 shown in Fig. 5 (b) is formed on an InP semiconductor substrate 1 and that anti-reflection (AR) coating films 9 are applied to both edge faces.

The grating is divided into two regions and a phase shift section 11 is interposed between these two regions. When the grating period is $\Lambda$, the amount of the phase shift is set to be $\Lambda/4$, corresponding to $\lambda/8$. In the present embodiment, the amount of this phase shift preferably corresponds to $\lambda/5 - \lambda/8$.

Because the active layer of the DFB laser of the present embodiment utilizes a tensile strain quantum well with a small linewidth enhancement factor and besides the phase shift section 11 with the amount of phase shifts corresponding to $\lambda/8$ is incorporated thereinto, in this manner, fluctuations of the optical output caused by return light can be inhibited. Consequently, the resistance against return light can be enhanced. Furthermore, shifts of the oscillation wavelength resulting from the direct modulation can be controlled and, therefore, a DFB laser with a low chirping can be accomplished.

Third embodiment

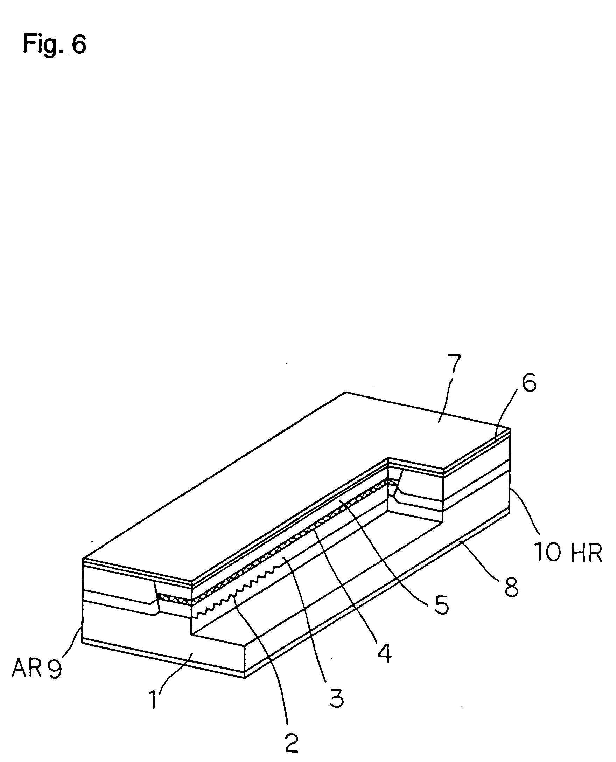

Fig. 6 is a schematic view showing a structure of a semiconductor laser that is a third embodiment of the present invention.

A semiconductor laser of the present embodiment has the same structure as the first embodiment except that a grating 2 is formed only partially along the direction of the cavity length and this grating formation region is specifically located on the side of the front edge face of the cavity and that an AR coating film is formed on a front edge face while a HR coating film is formed on a rear edge face.

Because the active layer of the DFB laser of the present embodiment utilizes a tensile strain quantum well with a small linewidth enhancement factor and besides a grating is set partially therein, in this manner, fluctuations of the optical output and the oscillation wavelength caused by return light and the direct modulation can be inhibited. Further, due to the presence of the edge face phase, the resistance against return light can be enhanced and the variations of chirping characteristics can be controlled.

Fourth embodiment

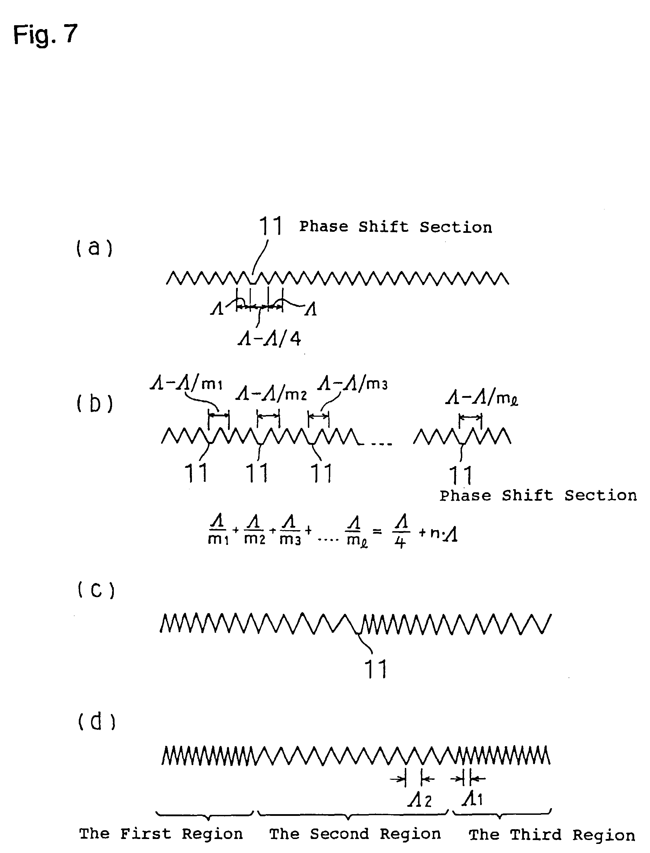

Fig. 7(a) is a schematic view showing a structure of a grating of a semiconductor laser that is a fourth embodiment of the present invention.

A semiconductor laser of the fourth embodiment has the same structure as the first embodiment except that a grating thereof has a different structure.

As shown in Fig. 7(a), a grating of the fourth embodiment has a structure in which a phase shift section 11 is located not at the center of the laser cavity but a position 1/4 of the cavity length distant from the front edge face. While it is set for the present embodiment that the amount of the phase shift corresponds to $\lambda/8$, it preferably corresponds to $\lambda/5 - \lambda/8$.

The distribution of the internal electric field in a phase-shifted DFB laser becomes centered in the vicinity of the phase-shift section. Owing to the structure of the present embodiment, the phase shift region is located around the front edge face (the face for laser emission) so that the field intensity around the front edge face becomes large, which enhances the resistance against return light and reduces chirping and, at the same time, improves the output efficiency of the laser.

Fifth to Seventh embodiments

Figs. 7(b) - (d) are schematic views showing respective structures of gratings of semiconductor lasers that are fifth to seventh embodiments of the present invention.

Semiconductor lasers of the fifth to seventh embodiments have the same structure as the first embodiment except that gratings thereof have different structures.

As shown in Fig. 7(b), a grating of the fifth embodiment has a structure in which the grating is divided into a plurality of regions and a phase shift section is interposed in every interval between said regions, and the sum of the amounts of the phase shifts of these phase shift sections, that is, the total amount of the phase shifts corresponds to $\lambda/8$. In the present embodiment, the amount of the phase shifts, in total, preferably corresponds to $\lambda/5 - \lambda/8$. In case the total amount of phase shifts is in this range, a laser with better resistance against return light can be attained.

As shown in Fig. 7(c), a grating of the sixth embodiment has a structure in which grating periods gradually increases from the center of the laser cavity towards one direction (right direction) and gradually decreases towards the other direction (left direction), with the rates of changes in both directions having the same absolute value but the reversed sign to each other. In the present embodiment, the amount of phase shifts with respect to the average grating period over the whole cavity corresponds to $\lambda/8$. In the present embodiment, the amount of phase shifts preferably corresponds to $\lambda/5 - \lambda/8$. In case the total amount of phase shifts, as a whole, is in this range, a laser with better resistance against return light can be attained.

As shown in Fig. 7(d), a grating of the seventh embodiment has a structure in which a laser cavity is divided into a plurality of regions along the direction of the cavity length and the grating period, at least, in one of these regions is different from the rest. In the present embodiment, the cavity is divided into three regions and the gratings in the first and the third regions have the same period $\Lambda 1$, while the grating in the second region has a different period $\Lambda 2$. With the grating period in the second region, the amount of the phase shifts over the whole grating corresponds to $\lambda/8$. In the present embodiment, the amount of the phase shifts over the whole grating preferably corresponds to $\lambda/5 - \lambda/8$. In case the amount of phase shifts as a whole is in this range, a laser with better resistance against return light can be attained.

In known phase-shifted DFB lasers, the distribution of the electric field is non-uniform, with the electric field being high in the central section (or in the phase-shift regions) and spatial hole burning is liable to happen. Against this, structures of the fifth to seventh embodiments can provide improvements in the uniformity of the field distribution in the inside of the laser cavity. Further, since the amount of the phase shifts in total is set to correspond to $\lambda/m$, the fluctuations of the optical output and the oscillation wavelength caused by return light and the direct modulation can be further inhibited and a DFB laser having good resistance against return light and low chirping can be attained.

**Claims**

1. A distributed feedback semiconductor laser whose optical feedback is provided at least by a diffraction grating; wherein

   an active layer has a quantum well structure comprising a well layer and a barrier layer; and
   said well layer is made of a tensile strain quantum well layer.

2. The distributed feedback semiconductor laser according to Claim 1, wherein a linewidth enhancement factor at the gain peak for said well layer is not greater than 3.

3. The distributed feedback semiconductor laser according to Claim 1; wherein

   said grating is formed only partially along the direction of the cavity length; and
   the region with said grating being formed is specifically located on the side of one edge face, while a high reflection coating film is applied onto the other edge face on the side where no grating is formed.

4. The distributed feedback semiconductor laser according to Claim 1; wherein

   a grating contained within the laser cavity is divided into M regions (M is an integer satisfying M>2) along the direction of the cavity length, and a phase shift section is interposed in every interval between said regions; and
   the total amount of phase shifts of said phase shift sections corresponds to $\lambda/m$ ($\lambda$ is the oscillation wavelength and m is a positive real number).

5. The distributed feedback semiconductor laser according to Claim 4; wherein

   said phase shift sections are specifically located on the side of the edge face for laser emission.

6. The distributed feedback semiconductor laser according to Claim 4 or 5; wherein the total amount of said phase shifts corresponds to $\lambda/5$ -$\lambda/8$.

7. The distributed feedback semiconductor laser according to Claim 1; wherein

   said grating is formed in such a manner as the grating period gradually changes from the center of the laser cavity towards both edge faces, with the rates of changes in both directions having the same absolute value but the reversed sign to each other.

8. The distributed feedback semiconductor laser according to Claim 1; wherein

   a grating contained within the laser cavity is divided into a plurality of regions along the direction of the cavity length, and the grating period, at least, in one of these regions is different from the rest; and
   the amount of phase shifts over the whole grating corresponds to $\lambda/m$ ($\lambda$ is the oscillation wavelength and m is a positive real number).

9. The distributed feedback semiconductor laser according to Claim 7 or 8; wherein the amount of said phase shifts over the whole grating corresponds to $\lambda/5$ -$\lambda/8$.

## Fig. 1

Return Light

Fluctuations of Optical Output
Fluctuations of Oscillation Wavelength

E
Electric
Field

Carrier Density N

Oscillation Threshold
Oscillation Wavelength

Equivalent Refractive Index $n_{eq}$

Mirror Loss $\alpha_m$
Amount of Detuning $\delta\beta$

## Fig. 2

## Fig. 3

Fig. 4

## Fig. 5

(a)

(b)

Fig. 6

## Fig. 7

(a)

$11$ Phase Shift Section

$\Lambda$ $\Lambda$

$\Lambda - \Lambda/4$

(b)

$\Lambda - \Lambda/m_1$ $\Lambda - \Lambda/m_2$ $\Lambda - \Lambda/m_3$ $\Lambda - \Lambda/m_\ell$

$11$ $11$ $11$ $11$

Phase Shift Section

$$\frac{\Lambda}{m_1} + \frac{\Lambda}{m_2} + \frac{\Lambda}{m_3} + \cdots \frac{\Lambda}{m_\ell} = \frac{\Lambda}{4} + n \cdot \Lambda$$

(c)

$11$

(d)

$\Lambda_2$ $\Lambda_1$

The First Region    The Second Region    The Third Region

# Fig. 8

## Prior Art